Europäisches Patentamt

European Patent Office

Office européen des brevets

(19)

(11) **EP 0 593 729 B1**

(12) **FASCICULE DE BREVET EUROPEEN**

(45) Date de publication et mention de la délivrance du brevet:
**06.11.1996 Bulletin 1996/45**

(21) Numéro de dépôt: **93910096.2**

(22) Date de dépôt: **07.05.1993**

(51) Int Cl.⁶: **H03M 1/00**, H03M 1/36, H04N 5/16

(86) Numéro de dépôt international:
**PCT/FR93/00443**

(87) Numéro de publication internationale:
**WO 93/22840 (11.11.1993 Gazette 1993/27)**

(54) **CONVERTISSEUR ANALOGIQUE-NUMERIQUE ET BOUCLE D'ASSERVISSEMENT UTILISANT UN TEL CONVERTISSEUR**

ANALOG DIGITALWANDLER UND EINEN SOLCHEN ANALOG DIGITALWANDLER BENUTZENDEREGELSCHLEIFE.

ANALOG-TO-DIGITAL CONVERTER AND FEEDBACK LOOP USING SAME

(84) Etats contractants désignés:
**DE ES FR GB IT**

(30) Priorité: **07.05.1992 FR 9205637**

(43) Date de publication de la demande:
**27.04.1994 Bulletin 1994/17**

(73) Titulaire: **THOMSON multimedia**
**92400 Courbevoie (FR)**

(72) Inventeur: **AUFFRET, Eric**
**F-92402 Courbevoie Cédex (FR)**

(74) Mandataire: **Ruellan-Lemonnier, Brigitte et al**
**THOMSON Multimedia,**
**9 Place des Vosges**
**La Défense 5**
**92050 Paris La Défense (FR)**

(56) Documents cités:
EP-A- 0 396 746        GB-A- 2 082 410
US-A- 4 554 671        US-A- 4 635 036
US-A- 4 982 191        US-A- 5 099 240

Remarques:
Le dossier contient des informations techniques présentées postérieurement au dépôt de la demande et ne figurant pas dans le présent fascicule.

Printed by Jouve, 75001 PARIS (FR)

## Description

La présente invention concerne un convertisseur analogique-numérique.

Elle concerne aussi une boucle d'asservissement permettant la restitution de la composante continue d'un signal vidéo, communément appelé clamp ou rétroclamp.

Les convertisseurs analogiques-numériques sont utilisés en électronique quand le codage numérique de l'information intervient.

Un convertisseur analogique-numérique (CAN) a pour fonction de convertir en données numériques une grandeur électrique analogique. Cette grandeur électrique analogique peut être soit une tension, soit un courant. Comme cela est connu de l'homme de l'art, un convertisseur analogique-numérique de n bits délivre $2^n$ combinaisons ayant chacune n bits de résolution. La précision d'un tel convertisseur est donnée par le basculement du bit de plus faible poids, noté LSB (Least Significant Bit). Selon l'art antérieur, cette précision est la même quelle que soit la valeur de la grandeur d'entrée. Selon les applications désirées, ceci peut représenter un inconvénient. Il en est ainsi, par exemple, des boucles d'asservissement utilisant des convertisseurs analogiques-numériques afin de restituer la composante continue d'un signal vidéo.

L'opération de restitution de la composante continue a pour but de fixer la tension continue de référence du signal vidéo à une valeur précise. Selon cette opération, le signal vidéo de chaque ligne est échantillonné sur sa composante continue ou niveau de noir. Une fraction de chaque échantillon est prélevée et comparée à une valeur de référence de façon à générer un signal d'erreur qui est réinjecté, éventuellement après amplification, dans le signal vidéo.

Plusieurs méthodes sont connues de l'homme de l'art afin de réaliser cette opération et notamment une méthode numérique selon laquelle le prélèvement de la composante continue est effectuée après conversion dudit signal en code numérique.

Comme cela a été mentionné précédemment, le niveau continu prélevé en sortie du convertisseur analogique-numérique est alors défini avec une précision de ± 1 LSB. La composante continue présente alors une oscillation de ± 1 bit de quantification autour de la consigne, ce qui a pour conséquence d'empêcher sa stabilisation.

L'invention ne présente pas cet inconvénient.

La présente invention a pour objet un convertisseur analogique-numérique de tension comprenant $2^n$ - 1 comparateurs permettant de générer $2^n$ niveaux de tension différents quand la tension d'entrée varie, et un circuit de codage binaire comprenant des moyens pour transformer les $2^n$ niveaux de tension en $2^n$ codes binaires ayant chacun n bits de résolution, caractérisé en ce qu'il comprend des moyens supplémentaires permettant de coder la tension contenue dans au moins une plage de variation de la tension d'entrée en une information ayant un nombre de bits de résolution supérieur à n.

Il est connu d'augmenter le nombre de bits de résolution d'un convertisseur analogique-numérique en utilisant un CAN auxiliaire pour convertir un certain nombre de bits de poids faible supplémentaire. on citera les CAN dits double-flash et les CAN à sous-gammes (cf. US-A-5 099 240). Contrairement à l'invention, ces CAN ont une résolution constante sur toute la plage de conversion et sont par conséquent plus complexes. Sont également connus des CAN flash logarithmiques qui ont une résolution variable sur leur gamme de conversion (cf. US-A-4 554 671). Il n'y a pas, dans ce type de convertisseur, de moyens supplémentaires actifs sur une partie seulement de la plage de conversion.

La présente invention a aussi pour objet une boucle d'asservissement de la composante continue d'un signal vidéo, caractérisée en ce qu'elle contient un convertisseur analogique-numérique selon l'invention.

Un avantage de l'invention est donc de stabiliser correctement le niveau de la composante continue.

D'autres caractéristiques et avantages de l'invention apparaîtront à la lecture d'un mode de réalisation préférentiel fait avec référence aux figures ci-annexées dans lesquelles :

- la figure 1 décrit un convertisseur analogique-numérique selon l'art antérieur;
- la figure 2 décrit une courbe de conversion du convertisseur décrit en figure 1;
- la figure 3 représente un exemple de convertisseur analogique-numérique selon l'invention ;
- la figure 4 décrit la courbe de conversion du convertisseur décrit en figure 3 ;
- la figure 5 représente un convertisseur analogique-numérique selon le mode de réalisation préférentiel de l'invention ;
- la figure 6 représente une application du convertisseur décrit en figure 5 ;

Sur toutes les figures, les mêmes repères désignent les mêmes éléments.

Selon les modes de réalisation de l'invention décrits, la grandeur électrique analogique d'entrée est une tension.

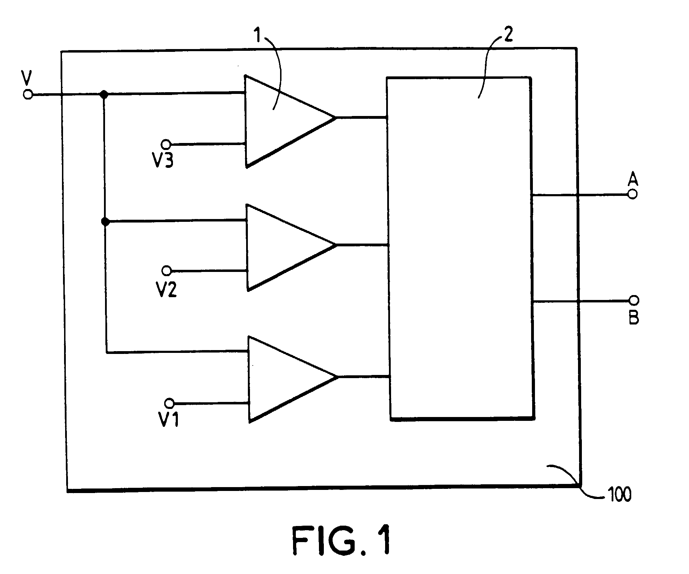

La figure 1 décrit un convertisseur analogique-numérique 100 selon l'art antérieur. Il s'agit d'un convertisseur connu de l'homme de l'art sous le nom de convertisseur flash. Pour des raisons de simplification, le dispositif représenté sur la figure 1 est un convertisseur de 2 bits délivrant 4 combinaisons. Comme cela est connu de l'homme de l'art, ce convertisseur contient 3 comparateurs 1. De façon générale, un convertisseur de type flash de n bits contient $2^n - 1$ comparateurs.

Le convertisseur de la figure 1 est tel que la tension analogique d'entrée V est comparée à 3 tensions de référence V1, V2, V3 à l'aide de 3 comparateurs.

Selon que la tension V est supérieure ou inférieure aux tensions de référence, le signal issu de chaque comparateur prend une première valeur ou une deuxième valeur parmi deux valeurs possibles. Les différents signaux issus des comparateurs sont alors envoyés dans un circuit logique 2 permettant, comme cela est connu de l'homme de l'art, de coder en binaire les informations qu'il reçoit sous la forme de combinaisons de 2 bits. Un bit est recueilli au point A et l'autre au point B. Il y a 4 combinaisons = (0,0), (01), (1,0), (1;1).

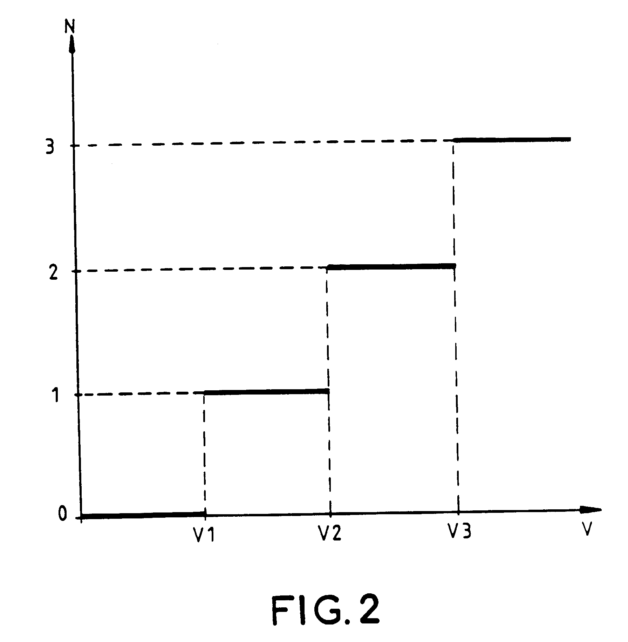

La figure 2 décrit la courbe de conversion du convertisseur décrit en figure 1.

Cette courbe associe la tension d'entrée V aux codes binaires par les rangs ou niveaux N qui permettent de les symboliser. Il est alors possible de dresser le tableau suivant :

$$
\begin{array}{llll}
 & V < V1 : & N = 0 & \text{code } (0, 0) \\
V1 \quad < & V < V2 : & N = 1 & \text{code } (0, 1) \\
V2 \quad < & V < V3 : & N = 2 & \text{code } (1, 0) \\
 & V > V3 : & N = 3 & \text{code } (1, 1)
\end{array}
$$

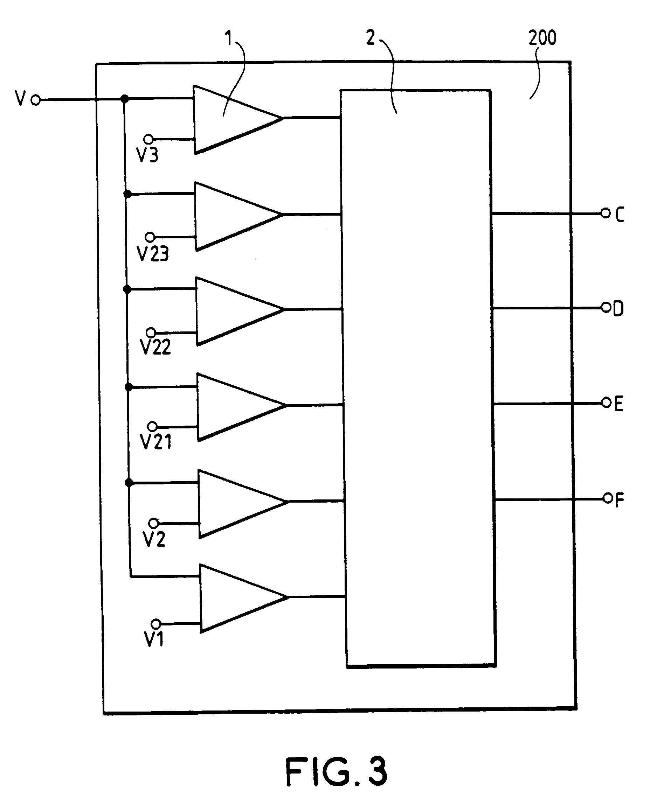

La figure 3 représente un exemple de convertisseur analogique-numérique selon un mode de réalisation de l'invention.

De même que le convertisseur 100 décrit en figure 1, le convertisseur 200 décrit en figure 3 contient 3 comparateurs associés aux tensions respectives V1, V2, V3.

Selon l'exemple de réalisation de l'invention, 3 comparateurs supplémentaires permettent la comparaison de la tension analogique V avec les tensions de référence respectives V21, V22, V23. Ces tensions sont comprises, par exemple, dans l'intervalle situé entre les tensions V2 et V3 de façon que :

$$V3 - V23 = V23 - V22 = V22 - V21 = V21 - V2$$

Un circuit logique de codage binaire 2 recueille les signaux issus des différents comparateurs. Les codes binaires générés par le circuit 2 sont des combinaisons de 4 bits recueillis respectivement aux points C, D, E, F.

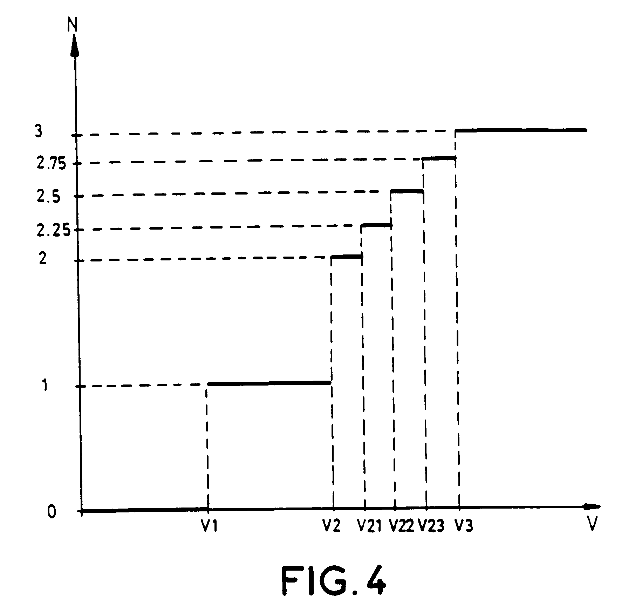

La figure 4 décrit la courbe de conversion du convertisseur de la figure 3.

Le fait d'ajouter 3 comparateurs permet de définir 3 niveaux supplémentaires (2.25, 2.5, 2.75) situés entre les niveaux 2 et 3.

Selon l'invention, la précision du convertisseur est multipliée par 4 lorsque la tension analogique V varie entre V2 et V3 puisque le convertisseur délivre deux bits de résolution supplémentaires.

On peut alors dresser le tableau suivant :

| Variation de V | Niveau | Bit recueilli en C | Bit recueilli en D | Bit recueilli en E | Bit recueilli en F |
|---|---|---|---|---|---|
| V < V1 | 0 | 0 | 0 | 0 | 0 |
| V1 < V < V2 | 1 | 0 | 1 | 0 | 0 |
| V2 < V < V21 | 2 | 1 | 0 | 0 | 0 , |
| V21 < V < V22 | 2.25 | 1 | 0 | 0 | 1 |
| V22 < V < V23 | 2.5 | 1 | 0 | 1 | 0 |
| V23 < V < V3 | 2.75 | 1 | 0 | 1 | 1 |
| V > V3 | 3 | 1 | 1 | 0 | 0 |

Les codes binaires recueillis aux points C et D du convertisseur 200 sont identiques aux codes binaires respectivement recueillis aux points A et B du convertisseur 100. Les codes binaires recueillis aux points E et F sont associés aux informations délivrées par les 3 comparateurs supplémentaires. Ces comparateurs permettent de générer 4 combinaisons de 2 bits chacune quand la tension V est comprise entre les valeurs V2 et V3.

Quand la tension V est inférieure à V2 ou supérieure à V3, le circuit logique 2 force les bits à zéro par tout moyen connu de l'homme de l'art et qu'il n'est donc pas nécessaire de rappeler dans la présente demande.

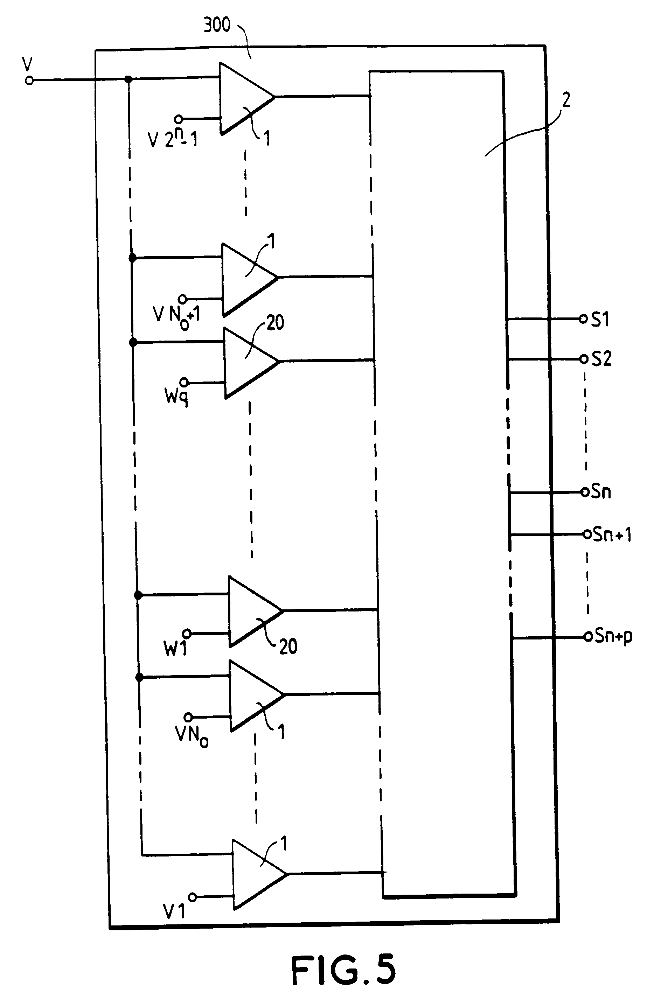

La figure 5 représente, un convertisseur analogique-numérique selon le mode de réalisation préférentiel de l'invention. Il s'agit de la généralisation du convertisseur analogique-numérique décrit en figure 3.

Le convertisseur analogique-numérique 300 comprend un premier ensemble de $2^n$-1 comparateurs 1. Chaque comparateur est associé à une tension $V_i (i = 1, 2, ---, 2^n - 1)$. De préférence les tensions $V_i$ sont espacées de façon que :

$$V_{j+1} - V_j = V_j - V_{j-1} \ (j = 1, 2, ---, 2^n - 1)$$

Les $2^n - 1$ comparateurs définissent $2^n$ niveaux de tension différents ($N = 1, 2 ---, 2^n$).

Selon l'invention, le convertisseur 300 comprend q comparateurs supplémentaires 20. Chacun de ces comparateurs est associé à une tension $W_k$ ($k = 1, 2, ---, q$) comprise entre deux tensions successives $VN_o$ et $V(N_o+1)$, prises parmi les $2^n - 1$ tensions mentionnées ci-dessus.

De préférence les tensions $W_k$ sont choisies de façon que :

$$V(N_o+1) - W_q = W_q - W_{(q-1)} = --- = W2 - W1 = W1 - VN_o.$$

Les q comparateurs supplémentaires permettent de définir $NI = q + 1$ niveaux intermédiaires situés entre le niveau $N_o$ et le niveau $N_o + 1$.

Selon le premier mode de réalisation de l'invention, le circuit de codage binaire 2 convertit d'une part l'information constituée par les $2^n$ niveaux en codes de n bits et, d'autre part, l'information constituée par les NI niveaux intermédiaires en codes de p bits. Comme cela est connu de l'homme de l'art, le nombre NI doit être un nombre entier égal à une puissance de 2. Il vient donc $q = 2^p-1$.

Les codes binaires de n bits sont recueillis sur les sorties S1, S2 --- Sn, et les codes binaires de p bits sur les sorties $S_{n+1}$, --- $S_{n+p}$.

A la manière de ce qui a été mentionné précédemment, le circuit de codage binaire comprend des moyens permettant de forcer à zéro les combinaisons des p bits pour tous les niveaux entiers de 1 à $2^n$, c'est-à-dire ailleurs que dans la zone d'intérêt.

Selon le mode de réalisation préférentiel de l'invention n = 8 et p = 2.

Selon le mode de réalisation préférentiel de l'invention, le convertisseur analogique-numérique qui vient d'être décrit comprend un seul sous-ensemble de q comparateurs supplémentaires situés entre deux niveaux entiers successifs. Il est évident que l'invention concerne aussi des convertisseurs analogiques-numériques contenant plusieurs sous-ensembles de comparateurs supplémentaires tels que celui décrit ci-dessus.

Selon l'invention les niveaux supplémentaires générés par un sous-ensemble de q comparateurs peuvent être situés entre deux niveaux entiers successifs, comme décrit ci-dessus, ou bien de part et d'autre d'un ou de plusieurs niveaux entiers.

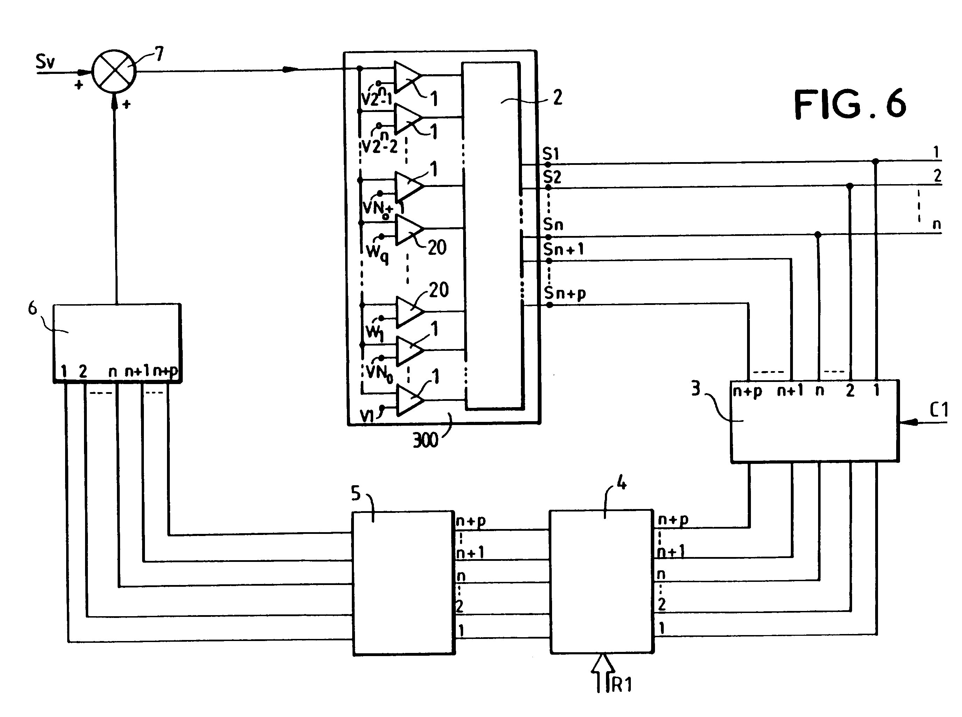

La figure 6 représente une application du convertisseur décrit en figure 5.

Le convertisseur analogique-numérique 300 est situé dans une boucle d'asservissement de la composante continue d'un signal vidéo Sv.

Le niveau $N_o$ associé à la tension VNo représente alors la composante continue du signal vidéo. Selon le mode de réalisation préférentiel, $N_o = 16$. C'est le niveau actuellement préconisé par la norme internationale d'échantillonnage du signal de luminance (norme 4 : 2 : 2). Cependant un niveau différent du niveau 16 pourrait tout aussi bien être choisi, par exemple le niveau 128 qui correspond au signal de chrominance.

Il a été mentionné précédemment que selon le mode de réalisation préférentiel n = 8 et p = 2. Les niveaux intermédiaires sont alors au nombre de 3 (16.25, 16.50, 16.75).

Les combinaisons des p bits supplémentaires ne sont significatives que pour les niveaux intermédiaires non entiers (par exemple 16.25, 16.50 et 16.75 selon le mode de réalisation préférentiel de l'invention) car, comme cela a été mentionné précédemment, le circuit de codage binaire 2 comprend des moyens permettant de forcer à zéro les combinaisons des p bits pour tous les niveaux entiers de 1 à $2^n$, c'est-à-dire ailleurs que dans la zone ou les niveaux intermédiaires ont de l'intérêt.

Selon l'invention, le dispositif de la figure 6 permet d'asservir la composante continue du signal vidéo de façon à supprimer l'oscillation de + 1 bit de quantification qui est présente dans les dispositifs de l'art antérieur. A cette fin, la boucle d'asservissement utilise le code constitué en sortie du convertisseur analogique-numérique 300 par les m = n + p bits. Ce code est envoyé dans un portier logique 3. Une commande C1 permet d'échantillonner le portier logique 3 au rythme d'apparition du niveau de noir du signal vidéo d'entrée Sv. Les codes utilisés autour de la composante continue sont alors comparés à l'aide du comparateur 4 à un code de référence R1 dont la combinaison est identique à l'une de celles dont les codes à p bits sont significatifs.

Le signal d'erreur issu du comparateur 4 est alors transféré à l'aide du filtre de boucle 5, par exemple un intégrateur-numérique, vers un convertisseur numérique analogique 6 qui transforme l'erreur numérique en tension d'erreur analogique appliquée à l'additionneur algébrique 7 de façon à réajuster le niveau continu de la tension.

Selon le mode de réalisation préférentiel, le code de référence R1 est identique à celui qui correspond au niveau 16.50. Comme cela a été mentionné précédemment, la précision obtenue en régime établi est donnée par le basculement du bit de plus faible poids. Selon le mode de réalisation préférentiel, la précision obtenue est donc égale à $\pm$ 0.25 LSB autour de la consigne de référence R1, où LSB désigne le bit de plus faible poids des codes à n bits. En régime établi, le niveau continu de la composante vidéo est ainsi fixé au niveau 16, sans oscillation parasite. De façon générale, la précision du convertisseur analogique-numérique est égale à $\pm$ 1 LSB/$2^P$.

On peut noter que l'utilisation d'un convertisseur analogique-numérique conventionnel de m bits, délivrant $2^m$ combinaisons permet d'appliquer le principe décrit dans ce document. Cela présente cependant un inconvénient majeur en terme de coût car la surface du silicium qui permet de réaliser le composant est augmentée de façon très significative, ainsi que la consommation. De plus, il n'est pas nécessairement requis que la précision soit ainsi étendue sur l'ensemble du convertisseur.

## Revendications

1. Convertisseur analogique-numérique (300) de tension comprenant $2^n$ - 1 comparateurs (1) permettant de générer $2^n$ niveaux de tension différents quand la tension d'entrée varie, entre un niveau minimum et un niveau maximum et un circuit de codage binaire comprenant des moyens pour transformer les $2^n$ niveaux de tension en $2^n$ codes binaires ayant chacun n bits de résolution, caractérisé en ce qu'il comprend des moyens supplémentaires (20) permettant de coder la tension contenue dans au moins une plage de variation de la tension d'entrée comprise entre les niveaux minimum et maximum en une information ayant un nombre de bits de résolution supérieur à n, la ou lesdites plages de variation de tension ne couvrant pas toute l'excursion de la tension d'entrée.

2. Convertisseur analogique-numérique (300) selon la revendication 1, caractérisé en ce que les moyens supplémentaires comprennent au moins un ensemble de $2^p$ - 1 comparateurs permettant de générer $2^p$ niveaux de tension situés entre un premier niveau (No) et deuxième niveau (No + 1), lesdits premier et deuxième niveaux étant deux niveaux successifs choisis parmi les $2^n$ niveaux et en ce que le circuit de codage binaire (2) comprend des moyens pour transformer les $2^p$ niveaux de tension en $2^p$ codes binaires de p bits chacun de façon que la tension d'entrée soit convertie en une combinaison de n + p bits prise parmi les $2^n$ + $2^p$ combinaisons disponibles en sortie du convertisseur.

3. Convertisseur analogique-numérique selon la revendication 2, caractérisé en ce que le circuit de codage binaire (2) comprend des moyens pour forcer à zéro les p bits des $2^n$ combinaisons associées auxdits $2^n$ niveaux de tension.

4. Boucle d'asservissement de la composante continue d'un signal vidéo, caractérisée en ce qu'elle contient un convertisseur analogique-numérique selon l'une quelconque des revendications précédentes, ledit convertisseur étant tel que le premier niveau (No) choisi parmi les $2^n$ niveaux correspond au niveau de stabilisation de ladite composante continue.

5. Boucle d'asservissement selon la revendication 4, caractérisée en ce qu'elle comprend un portier logique (3) relié au convertisseur analogique-numérique et permettant d'échantillonner le signal issu du convertisseur au rythme d'apparition de la composante continue sous l'influence d'une commande extérieure (C1), un comparateur (4) recueillant l'information issue du portier logique (3) et comparant ladite information à un code de référence (R1) dont la combinaison est identique à l'une de celles dont les codes à p bits sont non nuls, un filtre de boucle (5) recueillant le signal issu du comparateur, un convertisseur numérique-analogique (6) qui transforme le signal issu du filtre de boucle (5) en tension d'erreur analogique, et un additionneur algébrique (7) recueillant la tension d'erreur analogique de façon à réajuster le niveau de la composante continue.

## Patentansprüche

1. Analog-Digital-Spannungswandler (300) mit 2n - 1 Vergleichern (1), die die Erzeugung von 2n unterschiedlichen Spannungspegeln erlauben, wenn die Eingangsspannung zwischen einem Mindest- und einem Höchstpegel schwankt, und einer binären Codierschaltung mit Mitteln zum Umformen der 2n Spannungspegel in 2n Binärcodes jeweils mit n Bit Auflösung, dadurch gekennzeichnet, daß er Zusatzmittel (20) umfaßt, die die Codierung der Gleichspannung in mindestens einem Bereich der Veränderung der Eingangsspannung zwischen dem Mindest- und dem Höchstpegel in eine Information mit einer Anzahl von Auflösungsbit erlauben, die höher als n ist, wobei der oder die besagten Bereiche der Spannungsveränderung nicht den gesamten Ausschlag der Eingangsspannung abdecken.

2.  Analog-Digital-Spannungswandler (300) nach Anspruch 1, dadurch gekennzeichnet, daß die Zusatzmittel mindestens eine Gruppe von 2p - 1 Vergleichern umfassen, die die Erzeugung von 2p Spannungspegeln zwischen einem ersten Pegel (No) und zweiten Pegel (No + 1) erlauben, wobei der besagte erste und zweite Pegel zwei aufeinanderfolgende, unter den 2n Pegeln gewählte Pegel sind, und daß die binäre Codierschaltung (2) Mittel zum Umformen der 2p Spannungspegel in 2p Binärcodes von jeweils p Bit umfaßt, so daß die Eingangsspannung in eine Kombination von n + p Bit umgewandelt wird, die aus den 2n + 2p, am Ausgang des Wandlers verfügbaren Kombinationen entnommen worden ist.

3.  Analog-Digital-Spannungswandler nach Anspruch 2, dadurch gekennzeichnet, daß die binäre Codierschaltung (2) Mittel zum Nullsetzen der p Bit der mit den 2n Spannungspegeln verbundenen 2n Kombinationen umfaßt.

4.  Regelschleife der Gleichkomponente eines Videosignals, dadurch gekennzeichnet, daß sie einen Analog-Digital-Spannungswandler nach einem der vorhergehenden Ansprüche enthält, der so beschaffen ist, daß der erste unter den 2n Pegeln gewählte Pegel (No) dem Stabilisierungspegel der besagten Gleichkomponente entspricht.

5.  Regelschleife nach Anspruch 4, dadurch gekennzeichnet, daß sie folgendes umfaßt: ein mit dem Digital-Analog-Wandler verbundenes Logikgatter (3), das die Abtastung des vom Wandler abgegebenen Signals im Raster des Erscheinens der Gleichkomponente unter dem Einfluß eines externen Befehls (C1) erlaubt, einen die vom Logikgatter (3) abgegebene Information aufnehmenden und die besagte Information mit einem Bezugscode (R1) vergleichenden Vergleicher (4), wobei die Kombination des Bezugscodes einer von denen gleich ist, deren p-Bit-Code nicht Null sind, einen das vom Vergleicher abgegebene Signal aufnehmenden Schleifenfilter (5), einen Analog-Digital-Wandler (6), der das vom Schleifenfilter (5) abgegebene Signal in eine analoge Fehlerspannung umformt, und einen algebraischen Summierer (7), der die analoge Fehlerspannung zur Neueinstellung des Pegels der Gleichkomponente aufnimmt.

## Claims

1.  Analogue-digital voltage converter (300) comprising $2^n$ -1 comparators (1) making it possible to generate $2^n$ different voltage levels when the input voltage varies between a minimum level and a maximum level, and a binary coding circuit comprising means for converting the $2^n$ voltage levels into $2^n$ binary codes each having n bits of resolution, characterized in that it comprises additional means (20) making it possible to code the voltage contained in at least one range of variation of the input voltage lying between the minimum and maximum levels into an item of information having a number of bits of resolution greater than n, the range or ranges of voltage variation not covering the whole excursion of the input voltage.

2.  Analogue-digital converter (300) according to Claim 1, characterized in that the additional means comprise at least one set of $2^p$ - 1 comparators making it possible to generate $2^p$ voltage levels situated between a first level ($N_o$) and second level ($N_o + 1$), the said first and second levels being two successive levels chosen from among the $2^n$ levels and in that the binary coding circuit (2) comprises means for converting the $2^p$ voltage levels into $2^p$ binary codes each of p bits so that the input voltage is converted into a combination of n + p bits taken from among the $2^n + 2^p$ combinations available at the output of the converter.

3.  Analogue-digital converter according to Claim 2, characterized in that the binary coding circuit (2) comprises means for forcing to zero the p bits of the $2^n$ combinations associated with the said $2^n$ voltage levels.

4.  Loop for slaving the DC component of a video signal, characterized in that it contains an analogue-digital converter according to any one of the preceding claims, the said converter being such that the first level ($N_o$) chosen from among the $2^n$ levels corresponds to the level of stabilization of the said DC component.

5. Slaving loop according to Claim 4, characterized in that it comprises a logic gatekeeper (3) linked to the analogue-digital converter and making it possible to sample the signal output from the converter at the rate of appearance of the DC component under the influence of an external command (C1), a comparator (4) gathering the information output from the logic gatekeeper (3) and comparing the said information to a reference code (R1) the combination of which is identical to one of those of which the p-bit codes are non-zero, a loop filter (5) receiving the signal output by the comparator, a digital-analogue converter (6) which converts the signal output by the loop filter (5) into an analogue error voltage, and an algebraic adder (7) receiving the analogue error voltage in such a way as to readjust the level of the DC component.

FIG. 1

FIG. 2

FIG.3

FIG. 4

# FIG.5

FIG. 6